(19) Europäisches Patentamt / European Patent Office / Office européen des brevets

(11) **EP 3 207 634 B1**

(12) **EUROPÄISCHE PATENTSCHRIFT**

(45) Veröffentlichungstag und Bekanntmachung des Hinweises auf die Patenterteilung:
**20.06.2018 Patentblatt 2018/25**

(21) Anmeldenummer: **15781336.1**

(22) Anmeldetag: **14.10.2015**

(51) Int Cl.:
*H03L 7/091* (2006.01)   *G01R 19/25* (2006.01)

(86) Internationale Anmeldenummer:
**PCT/EP2015/073735**

(87) Internationale Veröffentlichungsnummer:
**WO 2016/059088 (21.04.2016 Gazette 2016/16)**

(54) **PHASENDETEKTIONSVERFAHREN BASIEREND AUF EINER MEHRZAHL AUFEINANDERFOLGENDER WERTE EINES EMPFANGSSIGNALS**

PHASE DETECTION METHOD BASED ON A PLURALITY OF CONSECUTIVE VALUES OF A RECEIVING SIGNAL

PROCÉDÉ DE DÉTECTION DE PHASE BASÉ SUR UNE PLURALITÉ DE VALEURS SUCCESSIVES D'UN SIGNAL DE RÉCEPTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.10.2014 DE 102014015127**

(43) Veröffentlichungstag der Anmeldung:
**23.08.2017 Patentblatt 2017/34**

(73) Patentinhaber: **SoNovum AG**
**04103 Leipzig (DE)**

(72) Erfinder:
• **WROBEL, Miroslaw**
**97753 Karlstadt (DE)**
• **KOLANY, Adam**
**04317 Leipzig (DE)**

(74) Vertreter: **advotec.**
**Patent- und Rechtsanwälte**
**Beethovenstrasse 5**
**97080 Würzburg (DE)**

(56) Entgegenhaltungen:
WO-A1-2010/045978   WO-A1-2011/107801
DE-C1- 4 205 300   US-A- 5 854 995
US-B1- 6 246 267

**Beschreibung**

Die vorliegende Erfindung betrifft ein Phasendetektionsverfahren und einen Prozessor zum Bestimmen einer Phase eines Empfangssignals basierend auf einer Mehrzahl aufeinanderfolgender Werte eines Empfangssignals.

Die genaue Bestimmung der Phase eines Ausgangssignals am Ausgang eines Übertragungsmediums bei Anregung am Eingang mit einem Eingangssignal bekannter Frequenz ist für eine Vielzahl von Anwendungen von Bedeutung. Beispielsweise kann die Phaseninformation in Kodierverfahren der Nachrichtentechnik dazu genutzt werden, um Nachrichten in Form von elektrischen, magnetischen oder elektro-magnetischen Signalen über einen Kommunikationskanal zu übertragen. Im Bereich der Materialwissenschaften gibt die Messung der Phase einer akustischen Welle Aufschluss über die Materialeigenschaften des Übertragungsmediums. In chemischen und physikalischen Analysesystemen werden Phasendetektoren genutzt, um Temperatur, Dichte, Phasenänderungen chemischer Reaktionen, Objektdimensionen und Flüssigkeitskonzentration in chemischen und physikalischen Medien zu bestimmen. In medizinischen Diagnostizierverfahren werden Eigenschaften von Geweben durch Messung der Phase von eingekoppelten akustischen und Ultraschall- Signalen ermittelt. Anwendungen hierzu sind die Überwachung der Blutzirkulation im Körper zur Erkennung krankhafter Zustände, insbesondere im Gehirn, und die Mammasonographie.

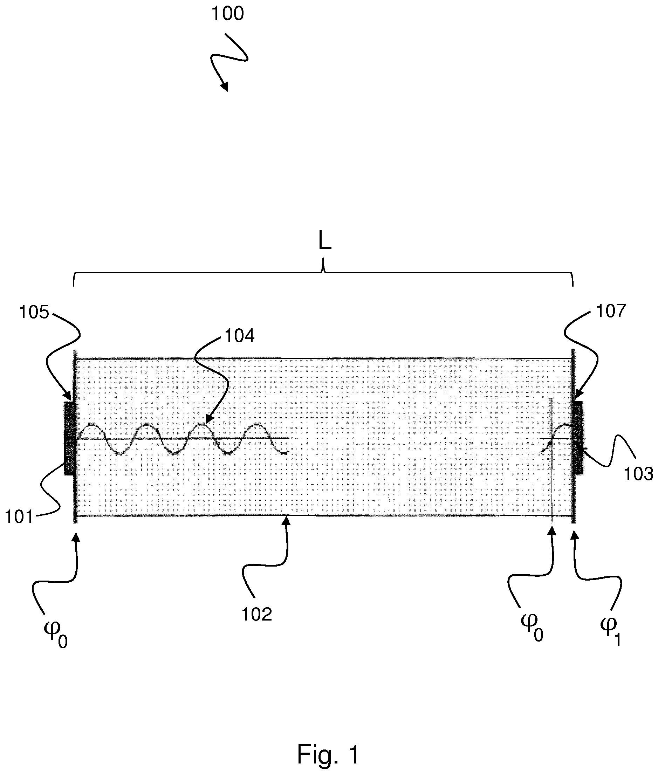

Fig. 1 zeigt eine schematische Darstellung eines Systems 100 zur Messung von Phasenbeziehungen akustischer Wellen in einem Gefäß 102. Das System 100 umfasst ein zu messendes Gefäß 102, beispielsweise eine Körperzelle, ein Blutgefäß oder eine Ader mit einer Gefäßlenge L und einen Sender 101 und Empfänger 103 von Ultraschallwellen. Der Sender 101 koppelt eine Ultraschallwelle 104 einer bekannten Frequenz $f_0$ mit Phase $\varphi_0$ an einem Eingang 105 des Gefäßes 102 in das Gefäß 102 ein, wo sie sich ausbreitet und am Ausgang 107 von dem Empfänger 103 empfangen wird. Wie aus Fig. 1 zu sehen ist, weist die Ultraschallwelle 104 in dem Gefäß 102 eine ganzzahlige Anzahl von Schwingungsperioden P auf sowie eine Teilperiode, die als Phasendifferenz $\varphi_1$ - $\varphi_0$ dargestellt werden kann. Zwischen der Laufzeit $T_p$ der akustischen Welle 104 und der Phasendifferenz $\varphi_1$ - $\varphi_0$ gilt die folgende Beziehung:

$$2\pi \cdot f_0 T_P = 2\pi P + (\varphi_1 - \varphi_0) \qquad (1)$$

Für die Phasengeschwindigkeit $V$ in dem Gefäß 102 gilt einerseits die Beziehung

$$V = \lambda \cdot f_0 \ , \qquad (2)$$

wobei $f_0$ die bekannte Sendefrequenz und $\lambda$ die Wellenlänge im Gefäß 102 bezeichnet. Andererseits gilt für die Phasengeschwindigkeit V in dem Gefäß 102 die Beziehung

$$V = \sqrt{\frac{K}{\rho}} \ , \qquad (3)$$

wobei $K$ die Elastizität des Gefäßes und $\rho$ seine Dichte angibt. Aus der Phasengeschwindigkeit $V$ lassen sich somit die Eigenschaften des Gefäßes 102 bestimmen. Die Wellenlänge $\lambda$ lässt sich aus der Anzahl der Perioden $P$ und der Phasendifferenz $\varphi_1$-$\varphi_0$, bestimmen und mittel der bekannten Sendefrequenz $f_0$ lässt sich die Phasengeschwindigkeit $V$ ermitteln, mit sich die Materialeigenschaften des Gefäßes 102 charakterisieren lassen.

Üblicherweise wird zum Bestimmen der Phasendifferenz $\varphi_1$-$\varphi_0$ der Empfänger mit dem Sender synchronisiert und über einen Analog-Digitalwandler das empfangene Signal abgetastet. Der Abtastwert des empfangenen Signals kann mit dem Synchronisationszeitpunkt in Beziehung gesetzt werden und daraus lässt sich die Phasendifferenz bestimmen.

Allerdings ist die Messgenauigkeit von einer Vielzahl an Systemparametern abhängig, wie beispielsweise der Genauigkeit der Abtastung, der Genauigkeit der Frequenzeinstellung des Sendesignals, Genauigkeit der Einkopplung und Auskopplung des akustischen Signals, Interferenzen des Sendesignals aufgrund Reflektionen an den Gefäßenden und Gefäßseiten, Dopplereffekten etc. Das Dokument "WO 2011/107801 A1" offenbart ein Phasendetektionsverfahren und einen Prozessor gemäß dem Oberbegriff der jeweiligen Ansprüche 1 und 7. Es ist die Aufgabe der vorliegenden Erfindung, ein Konzept für eine einfache und präzise Bestimmung der Phase am Ausgang eines Übertragungsmediums bei Anregung mit einem Sendesignal bekannter Signalcharakteristik zu schaffen.

Diese Aufgabe wird durch die Merkmale der unabhängigen Ansprüche gelöst. Vorteilhafte Weiterbildungsformen sind Gegenstand der abhängigen Ansprüche.

Die im Folgenden vorgestellten Verfahren, Vorrichtungen und Systeme können von verschiedener Art sein. Die einzelnen beschriebenen Elemente können durch Hardware- oder Softwarekomponenten realisiert sein, beispielsweise elektronische Komponenten, die durch verschiedene Technologien hergestellt werden können und zum Beispiel Halbleiterchips, ASICs, Mikroprozessoren, digitale Signalprozessoren, integrierte elektrische Schaltungen, elektrooptische Schaltungen und/oder passive Bauelemente umfassen.

Gemäß einem ersten Aspekt betrifft die Erfindung ein Phasendetektionsverfahren, mit folgenden Schritten: Empfangen einer Mehrzahl von aufeinanderfolgenden Werten eines Empfangssignals mit bekannter Abtastfrequenz $f_s$ als Reaktion auf ein Sendesignal mit bekannter Sendefrequenz $f_w$; Bestimmen von zwei Differenzwerten aus jeweils zwei aufeinanderfolgenden Werten von drei aufeinanderfolgenden Werte des Empfangssignals; und Bestimmen eines Phasenrealteils und eines Phasenimaginärteils des Empfangssignals basierend auf einer linearen Beziehung zwischen dem Phasenrealteil, dem Phasenimaginärteil und den zwei Differenzwerten.

Dies hat den Vorteil, dass die Phase am Ausgang eines Übertragungsmediums bei Anregung mit einem Sendesignal bekannter Signalcharakteristik einfach und präzise bestimmt werden kann. Bei bekannter Sendefrequenz und Abtastfrequenz ist die lineare Beziehung zwischen dem Phasenrealteil, dem Phasenimaginärteil und den zwei Differenzwerten mit geringem Aufwand zu bestimmen und liefert präzise Werte für die Phase des Empfangssignals.

Gemäß einer Ausführungsform des Phasendetektionsverfahrens ist die lineare Beziehung zwischen dem Phasenrealteil, dem Phasenimaginärteil und den zwei Differenzwerten durch ein zweidimensionales lineares Gleichungssystem darstellbar basierend auf den zwei Differenzwerten als Eingangsvariablen und dem Phasenrealteil und dem Phasenimaginärteil als Ausgangsvariablen.

Dies hat den Vorteil, dass das zweidimensionale lineare Gleichungssystem leicht auflösbar ist und die Terme für den Phasenrealteil und den Phasenimaginärteil einfach darstellbar und damit einfach zu bestimmen sind. Die Phase kann somit mit geringem Aufwand exakt bestimmt werden.

Gemäß einer Ausführungsform des Phasendetektionsverfahrens wird das lineare Gleichungssystem durch Gewichtung der Eingangsvariablen mit Fourier-Koeffizienten, die auf einer bekannten Kreisfrequenz $\Omega$ basieren, gelöst, wobei die bekannte Kreisfrequenz von der Sendefrequenz und der Abtastfrequenz abhängt.

Dies hat den Vorteil, dass bei bekannten Werte der Sendefrequenz $f_w$ und der Abtastfrequenz $f_s$ das lineare Gleichungssystem sich mittels der Fourier-Koeffizienten einfach auflösen lässt.

Gemäß einer Ausführungsform des Phasendetektionsverfahrens genügt die bekannte Kreisfrequenz der Beziehung $\Omega = 2\pi(f_w/f_s)$.

Gemäß einer Ausführungsform umfasst das Phasendetektionsverfahren ein Bestimmen der Fourier-Koeffizienten abhängig von der bekannten Kreisfrequenz $\Omega = 2\pi(f_w/f_s)$ vor dem Bestimmen des Phasenrealteils und des Phasenimaginärteils des Empfangssignals (Y).

Dies hat den Vorteil, dass bei bekannten Werte der Sendefrequenz $f_w$ und der Abtastfrequenz $f_s$ die Fourier-Koeffizienten bereits im Vorfeld bestimmt werden können und als Parameter abgelegt werden können, so dass das Verfahren sehr effizient durchführbar ist.

Gemäß einer Ausführungsform umfasst das Phasendetektionsverfahren ein Bestimmen eines Bias des Empfangssignals basierend auf einer linearen Beziehung zwischen dem Phasenrealteil, dem Phasenimaginärteil, dem Bias und den drei aufeinanderfolgenden Werten des Empfangssignals.

Dies hat den Vorteil, dass der Bias am Ausgang des Übertragungsmediums bei Anregung mit einem Sendesignal bekannter Signalcharakteristik einfach und präzise bestimmt werden kann. Bei bekannter Sendefrequenz und Abtastfrequenz ist die lineare Beziehung zwischen dem bereits bestimmten Phasenrealteil, dem bereits bestimmten Phasenimaginärteil, dem Bias und den zwei Differenzwerten mit geringem Aufwand zu bestimmen und liefert präzise Werte für den Bias des Empfangssignals.

Gemäß einem zweiten Aspekt betrifft die Erfindung einen Prozessor zum Bestimmen einer Phase eines als Reaktion auf ein Sendesignal mit bekannter Sendefrequenz $f_w$ empfangenen Empfangssignals mit bekannter Abtastfrequenz $f_s$, mit: einem ersten, zweiten und dritten Eingangsregister, die ausgelegt sind, jeweils nacheinander drei aufeinanderfolgende Werte aus einer Mehrzahl von aufeinanderfolgenden Werten des Empfangssignals zu speichern; einem ersten und zweiten internen Register, die ausgelegt sind, einen ersten Differenzwert als Differenz des Inhalts des zweiten Eingangsregisters und des Inhalts des ersten Eingangsregisters und einen zweiten Differenzwert als Differenz des Inhalts des dritten Eingangsregisters und des Inhalts des zweiten Eingangsregisters zu speichern; einem ersten und zweiten Ausgangsregister, die ausgelegt sind, einen Phasenrealteil und einen Phasenimaginärteil des Empfangssignals bereitzustellen; und einer Recheneinheit, die ausgelegt ist, den Phasenrealteil und den Phasenimaginärteil des Empfangssignals basierend auf einer linearen Beziehung zwischen dem Phasenrealteil, dem Phasenimaginärteil und den zwei Differenzwerten zu bestimmen.

Dies hat den Vorteil, dass der Prozessor die Phase am Ausgang eines Übertragungsmediums bei Anregung mit einem Sendesignal bekannter Signalcharakteristik einfach und präzise bestimmen kann. Bei bekannter Sendefrequenz und Abtastfrequenz kann der Prozessor die lineare Beziehung zwischen dem Phasenrealteil, dem Phasenimaginärteil und den zwei Differenzwerten mit geringem Aufwand bestimmen und somit präzise Werte für die Phase des Empfangssignals liefern.

Gemäß einer Ausführungsform umfasst der Prozessor ein drittes Ausgangsregister, das ausgelegt ist, einen Bias des Empfangssignals bereitzustellen, wobei die Recheneinheit ausgelegt ist, den Bias des Empfangssignals basierend auf einer linearen Beziehung zwischen dem Phasenrealteil, dem Phasenimaginärteil, dem Bias und den drei aufeinanderfolgenden Werten des Empfangssignals zu bestimmen.

Dies hat den Vorteil, dass der Prozessor den Bias am Ausgang des Übertragungsmediums bei Anregung mit einem Sendesignal bekannter Signalcharakteristik einfach und präzise bestimmen kann. Bei bekannter Sendefrequenz und Abtastfrequenz kann der Prozessor die lineare Beziehung zwischen dem bereits bestimmten Phasenrealteil, dem bereits bestimmten Phasenimaginärteil, dem Bias und den zwei Differenzwerten mit geringem Aufwand bestimmen und präzise Werte für den Bias des Empfangssignals liefern.

Gemäß einer Ausführungsform umfasst der Prozessor ein erstes, zweites, drittes und viertes Koeffizientenregister, die ausgelegt sind, Fourier-Koeffizienten zu speichern, wobei die Fourier-Koeffizienten die lineare Beziehung zwischen dem Phasenrealteil, dem Phasenimaginärteil und den zwei Differenzwerten bestimmen.

Dies hat den Vorteil, dass bei bekannten Werte der Sendefrequenz $f_w$ und der Abtastfrequenz $f_s$ der Prozessor die lineare Beziehung mittels der Fourier-Koeffizienten einfach bestimmen kann und somit die Phase effizient ermitteln kann.

Gemäß einer Ausführungsform umfasst der Prozessor einen ersten Parameterspeicher, der ausgelegt ist den Kosinus der Hälfte einer bekannten Kreisfrequenz $\Omega$, die von der Sendefrequenz und der Abtastfrequenz abhängt, zu speichern; einen zweiten Parameterspeicher, der ausgelegt ist den Sinus der Hälfte der bekannten Kreisfrequenz $\Omega$ zu speichern; einen dritten Parameterspeicher, der ausgelegt ist den Kosinus der bekannten Kreisfrequenz $\Omega$ zu speichern; und einen vierten Parameterspeicher, der ausgelegt ist den Sinus der bekannten Kreisfrequenz $\Omega$ zu speichern.

Dies hat den Vorteil, dass der Prozessor die für die Bestimmung der linearen Beziehung nötigen Größen bereits im Vorfeld ermitteln kann und diese in den vier Parameterspeichern ablegen kann oder dass diese Größen bereits von außen ermittelt wurden und bei Start des Prozessors in den vier Parameterspeichern vorliegen. Damit kann die Bestimmung der Phase sehr effizient ausgeführt werden.

Gemäß einer Ausführungsform des Prozessors genügt die bekannte Kreisfrequenz der Beziehung $\Omega = 2\pi(f_w/f_s)$.

Gemäß einer Ausführungsform des Prozessors ist die Recheneinheit ausgelegt, den Phasenrealteil und den Phasenimaginärteil des Empfangssignals basierend auf den Inhalten der vier Koeffizientenregister und den Inhalten der vier Parameterspeicher zu bestimmen.

Dies hat den Vorteil, dass die Recheneinheit zur Bestimmung der Phase mit bereits bestimmten und in den entsprechenden Registern vorhandenen Größen arbeiten kann, so dass der Prozessor die Bestimmung der Phase mit geringem Rechenaufwand ausführen kann.

Gemäß einer Ausführungsform umfasst der Prozessor eine Instruktionseinheit, die ausgelegt ist, ansprechend auf ein Reset-Signal das erste Koeffizientenregister mit dem Inhalt des ersten Parameterspeichers und das zweite Koeffizientenregister mit dem Inhalt des zweiten Parameterspeichers zu initialisieren; und ansprechend auf ein Takt-Signal das erste Koeffizientenregister mit dem Inhalt des dritten Koeffizientenregisters und das zweite Koeffizientenregister mit dem Inhalt des vierten Koeffizientenregisters zu erneuern.

Dies hat den Vorteil, dass der Prozessor durch das Reset-Signal in einen vordefinierten Anfangszustand versetzt werden kann und in jedem Takt eine Bestimmung der Phase durchführen kann, so dass die Phase sehr präzise und schnell bestimmt werden kann.

Gemäß einer Ausführungsform des Prozessors ist die Instruktionseinheit ausgelegt, ansprechend auf das Takt-Signal das vierte Koeffizientenregister mit dem Wert $C_1 wS + S_1 wC$ zu laden und das dritte Koeffizientenregister mit dem Wert $C_1 wC - S_1 wS$ zu laden, wobei $wS$ den Inhalt des vierten Parameterspeichers, $wC$ den Inhalt des dritten Parameterspeichers, $C_1$ den Inhalt des ersten Koeffizientenregister, $S_1$ den Inhalt des zweiten Koeffizientenregister angibt und $\Omega$ die bekannte Kreisfrequenz $\Omega = 2\pi(f_w/f_s)$ bezeichnet.

Dies hat den Vorteil, dass der Prozessor die Phase durch die einfachen Update-Regeln $C_1 wS + S_1 wC$ und $C_1 wC - S_1 wS$, die mittels Multiplikation-Addition Operationen in jedem Takt ausgeführt werden können, schnell bestimmen kann.

Gemäß einer Ausführungsform des Prozessors ist die Recheneinheit ausgelegt, den Phasenrealteil als

$$\frac{\Delta Y_1 \cdot S_2 - \Delta Y_2 \cdot S_1}{4hS \cdot hS \cdot hC}$$ und den Phasenimaginärteil als $$\frac{\Delta Y_1 \cdot C_2 - \Delta Y_2 \cdot C_1}{4hS \cdot hS \cdot hC}$$ zu bestimmen, wobei $hS$ den Inhalt des zweiten Parameterspeichers, $hC$ den Inhalt des ersten Parameterspeichers, $C_2$ den Inhalt des dritten Koeffizientenregisters, $S_2$ den Inhalt des vierten Koeffizientenregisters angibt und $\Omega$ die bekannte Kreisfrequenz $\Omega = 2\pi(f_w/f_s)$ bezeichnet.

Dies hat den Vorteil, dass der Prozessor die Phase durch die oben bezeichneten einfachen Gleichungen berechnen kann, welche die Recheneinheit mittels Multiplikation-Addition Operationen und einer Normierung mit Normierungsfaktor schnell bestimmen kann.

Gemäß einer Ausführungsform des Prozessors ist die Recheneinheit ausgelegt, den Bias als $Y_2 - (U \cdot (S_1 hC + C_1 hS) + V \cdot (C_1 hC - S_1 hS))$ zu bestimmen, wobei U den Phasenrealteil, V den Phasenimaginärteil und $Y_2$ den Inhalt des zweiten Eingangsregisters angibt.

Dies hat den Vorteil, dass der Prozessor den Bias durch die oben bezeichnete einfache Gleichung berechnen kann, welche die Recheneinheit mittels Multiplikation-Addition und Speicher-Operationen schnell bestimmen kann.

Gemäß einer Ausführungsform umfasst der Prozessor ein erstes Hilfsregister; ein zweites Hilfsregister; und einen Zähler, der mit jeder Erneuerung der drei Eingangsregister abhängig von dem Taktsignal inkrementiert wird, wobei die Recheneinheit ausgelegt ist, den Phasenrealteil als $\Delta Y_1 S_2 - \Delta Y_2 S_1$ und den Phasenimaginärteil als $\Delta Y_1 C_2 - \Delta Y_2 C_1$ zu bestimmen, den Phasenrealteil zu dem ersten Hilfsregister hinzuzuaddieren, und den Phasenimaginärteil zu dem zweiten Hilfsregister hinzuzuaddieren, wobei die Instruktionseinheit ausgelegt ist, ansprechend auf ein Interrupt-Signal die Werte der beiden Hilfsregister geteilt durch den Wert $2 \cdot wS \cdot hS = 4hS \cdot hS \cdot hC$ und geteilt durch einen Wert des Zählers auszugeben, wobei $\Delta Y_1$ den Inhalt des ersten internen Registers, $\Delta Y_2$ den Inhalt des zweiten internen Registers, $C_2$ den Inhalt des dritten Koeffizientenregisters, $S_2$ den Inhalt des vierten Koeffizientenregister, $hS$ den Inhalt des zweiten Parameterspeichers und $hC$ den Inhalt des ersten Parameterspeichers angibt, und $\Omega$ die bekannte Kreisfrequenz $\Omega = 2\pi(f_w/f_s)$ bezeichnet.

Dies hat den Vorteil, dass der Prozessor die Hilfsregister dazu nutzen kann, Zwischenergebnisse zu speichern, so dass er mittels Zugriff auf die Zwischenergebnisse und gesteuert durch das Interrupt-Signal die Phase sehr effizient berechnen kann.

Die Bestimmung der Phase und des Bias nach den hier beschriebenen Aspekten und Ausführungsbeispielen sind für eine Vielzahl von Anwendungen von Bedeutung. Beispielsweise kann die so bestimmte Phase bzw. der so bestimmte Bias in Kodierverfahren der Nachrichtentechnik dazu genutzt werden, um Nachrichten in Form von elektrischen, magnetischen oder elektro-magnetischen Signalen über einen Kommunikationskanal zu übertragen. Im Bereich der Materialwissenschaften kann die so bestimmte Phase bzw. der so bestimmte Bias in Bezug auf eine akustische Welle Aufschluss über die Materialeigenschaften des Übertragungsmediums geben. In chemischen und physikalischen Analysesystemen kann die so bestimmte Phase bzw. der so bestimmte Bias dazu genutzt werden, um Temperatur, Dichte, Phasenänderungen chemischer Reaktionen, Objektdimensionen und Flüssigkeitskonzentration in chemischen und physikalischen Medien zu bestimmen.

In medizinischen Diagnostizierverfahren kann bei eingekoppelten akustischen und Ultraschall- Signalen die nach den hier beschriebenen Aspekten und Ausführungsbeispielen bestimmte Phase bzw. Bias dazu genutzt werden, um Eigenschaften von Geweben zu ermitteln. Ausführungsbeispiele der Erfindung finden Anwendung beispielsweise bei der Überwachung der Blutzirkulation im Körper zur Erkennung krankhafter Zustände, insbesondere im Gehirn, und in der Mammasonographie. Die Phaseninformation kann hier Aufschluss geben sowohl über einen gesunden Zustand als auch einen kranken Zustand des Gewebes. Beispielsweise können mittels Messungen der Phase nach den hier vorgestellten Verfahren bzw. mit den hier vorgestellten Prozessoren an gesunden Patienten Informationen über einen gesunden Zustand des Gewebes gewonnen werden, die als eine Art Referenzwert dienen können. Bei Messungen an Patienten, bei denen die Phaseninformation gegenüber dem ermittelten Referenzwert abweicht, kann auf einen krankhaften Zustand des Patienten geschlossen werden.

Weitere Ausführungsbeispiele werden Bezug nehmend auf die beiliegenden Zeichnungen erläutert. Es zeigen:

Fig. 1 eine schematische Darstellung eines Systems 100 zur Messung von Phasenbeziehungen akustischer Wellen in einem Gefäß 102;

Fig. 2 eine schematische Darstellung eines Phasendetektionsverfahrens 200 gemäß einer Ausführungsform;

Fig. 3 eine schematische Darstellung eines Prozessors 300 zum Bestimmen einer Phase eines Empfangssignals gemäß einer ersten Ausführungsform; und

Fig. 4 eine schematische Darstellung eines Prozessors 400 zum Bestimmen einer Phase eines Empfangssignals gemäß einer zweiten Ausführungsform.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

Wenngleich ein bestimmtes Merkmal oder ein bestimmter Aspekt einer Ausführungsform bezüglich nur einer von mehreren Implementierungen offenbart worden sein mag, kann außerdem ein derartiges Merkmal oder ein derartiger Aspekt mit einem oder mehreren anderen Merkmalen oder Aspekten der anderen Implementierungen kombiniert werden, wie für eine gegebene oder bestimmte Anwendung erwünscht und vorteilhaft sein kann. Weiterhin sollen in dem Ausmaß, in dem die Ausdrücke "enthalten", "haben", "mit" oder andere Varianten davon entweder in der ausführlichen Beschreibung oder den Ansprüchen verwendet werden, solche Ausdrücke auf eine Weise ähnlich dem Ausdruck "umfassen" einschließend sein. Die Ausdrücke "gekoppelt" und "verbunden" können zusammen mit Ableitungen davon verwendet worden sein. Es versteht sich, dass derartige Ausdrücke dazu verwendet werden, um anzugeben, dass zwei Elemente unabhängig davon miteinander kooperieren oder interagieren, ob sie in direktem physischem oder elektrischem Kontakt stehen oder nicht in direktem Kontakt miteinander stehen. Außerdem ist der Ausdruck "beispielhaft" lediglich als ein Beispiel aufzufassen anstatt der Bezeichnung für das Beste oder Optimale. Die folgende Beschreibung ist deshalb nicht in einem einschränkenden Sinne zu verstehen.

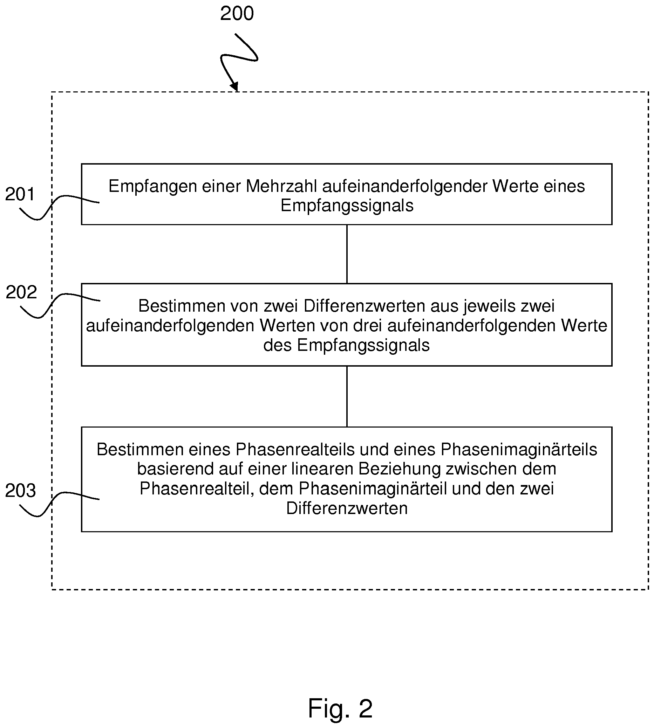

Fig. 2 zeigt eine schematische Darstellung eines Phasendetektionsverfahrens 200 gemäß einer Ausführungsform. Das Verfahren 200 umfasst ein Empfangen 201 einer Mehrzahl von aufeinanderfolgenden Werten eines Empfangssignals Y mit bekannter Abtastfrequenz $f_s$ als Reaktion auf ein Sendesignal mit bekannter Sendefrequenz $f_w$. Das Verfahren 200 umfasst ein Bestimmen 202 von zwei Differenzwerten $\Delta Y1$, $\Delta Y2$ aus jeweils zwei aufeinanderfolgenden Werten von drei aufeinanderfolgenden Werte Y1, Y2, Y3 des Empfangssignals Y. Das Verfahren 200 umfasst ein Bestimmen 203 eines Phasenrealteils U und eines Phasenimaginärteils V des Empfangssignals Y basierend auf einer linearen Beziehung zwischen dem Phasenrealteil U, dem Phasenimaginärteil V und den zwei Differenzwerten $\Delta Y1$, $\Delta Y2$.

Die lineare Beziehung zwischen dem Phasenrealteil U, dem Phasenimaginärteil V und den zwei Differenzwerten $\Delta Y1$, $\Delta Y2$ kann durch ein zweidimensionales lineares Gleichungssystem dargestellt werden basierend auf den zwei Differenzwerten $\Delta Y1$, $\Delta Y2$ als Eingangsvariablen und dem Phasenrealteil U und dem Phasenimaginärteil V als Ausgangsvariablen.

Das lineare Gleichungssystem kann durch Gewichtung der Eingangsvariablen mit Fourier-Koeffizienten, die auf einer bekannten Kreisfrequenz $\Omega$ basieren, gelöst werden, wobei die bekannte Kreisfrequenz $\Omega$ von der Sendefrequenz und der Abtastfrequenz abhängt.

Die bekannte Kreisfrequenz $\Omega$ kann der Beziehung $n=2\pi(f_w/f_s)$ genügen.

Die Fourier-Koeffizienten können abhängig von der bekannten Kreisfrequenz $\Omega$ vor dem Bestimmen des Phasenrealteils U und des Phasenimaginärteils (V) des Empfangssignals (Y) ermittelt werden.

Ein Bias $\beta$ des Empfangssignals Y kann basierend auf einer linearen Beziehung zwischen dem Phasenrealteil U, dem Phasenimaginärteil V, dem Bias $\beta$ und den drei aufeinanderfolgenden Werten Y1, Y2, Y3 des Empfangssignals Y bestimmt werden.

Die folgende Darstellung beschreibt die theoretischen Grundlagen des Verfahrens 200.

Gegeben seien drei Werte $Y_0, Y_1, Y_2$ einer Funktion

$$Y(\tau) = \beta + A\sin(2\pi \cdot f_w \tau + \varphi) \qquad (4)$$

mit den unbekannten Parametern $A$, $\beta$ und $\varphi$ und der bekannten Sendefrequenz $f_w$.
Die drei Werte $Y_0$, $Y_1$, $Y_2$ sind in drei äquidistanten Zeitpunkten

$$\tau_1, \ \tau_2 \ \text{und} \ \tau_3 \qquad (5)$$

gemessen worden, so dass gilt:

$$\Delta\tau = \tau_2 - \tau_1 = \tau_3 - \tau_2 < \frac{1}{2 \cdot f_w} . \qquad (6)$$

Diese Bedingung (6) gewährleistet (im Falle absoluter Messgenauigkeit) ein exaktes Rekonstruieren der Werte

$$U = A\cos(\varphi) \quad \text{und} \tag{7a}$$

$$V = A\sin(\varphi) \tag{7b}$$

und damit auch der Werte

$$A = \sqrt{U^2 + V^2} \quad \text{und} \tag{8a}$$

$$\varphi = (\arcsin(V/A) \bmod 2\pi), \tag{8b}$$

Die Werte $U$ und $V$ lösen das folgende lineare Gleichungssystem:

$$\begin{aligned} Y_1 &= U \cdot S_1 + V \cdot C_1 + \beta \\ Y_2 &= U \cdot S_2 + V \cdot C_2 + \beta, \\ Y_3 &= U \cdot S_3 + V \cdot C_3 + \beta \end{aligned} \tag{9}$$

wobei gilt:

$$S_j = \sin(2\pi \cdot f_w \cdot \tau_j), \quad j \in \{1,2,3\} \tag{10a}$$

$$C_j = \cos(2\pi \cdot f_w \cdot \tau_j), \quad j \in \{1,2,3\} \tag{10b}$$

Nach einigen einfachen Umformungen kann das Gleichungssystem (9) wie folgt dargestellt werden:

$$\begin{aligned} Y_2 - Y_1 &= U \cdot (S_2 - S_1) + V \cdot (C_2 - C_1) = 2\sin(\tfrac{\Omega}{2})(U \cdot \hat{C}_1 - V \cdot \hat{S}_1) \\ Y_3 - Y_2 &= U \cdot (S_3 - S_2) + V \cdot (C_3 - C_2) = 2\sin(\tfrac{\Omega}{2})(U \cdot \hat{C}_2 - V \cdot \hat{S}_2) \end{aligned}, \tag{11}$$

wobei gilt:

$$\Omega = 2\pi \cdot f_w \Delta\tau \tag{12}$$

und

$$\hat{S}_j = \sin(\Omega \cdot (j + \tfrac{1}{2})), \quad j \in \{1,2\} \tag{13a}$$

$$\hat{C}_j = \cos(\Omega \cdot (j + \tfrac{1}{2})), \quad j \in \{1,2\} \tag{13b}$$

Mit der Bezeichnung

$$\Delta Y_j = Y_{j+1} - Y_j, \quad j \in \{1,2\} \tag{14}$$

ergibt sich als Lösung für das System (11):

$$U = \frac{\Delta Y_1 \cdot \hat{S}_2 - \Delta Y_2 \cdot \hat{S}_1}{2 \sin(\frac{\Omega}{2}) \sin(\Omega)}, \tag{15a}$$

$$V = \frac{\Delta Y_1 \cdot \hat{C}_2 - \Delta Y_2 \cdot \hat{C}_1}{2 \sin(\frac{\Omega}{2}) \sin(\Omega)}, \tag{15b}$$

Eine weitere Reduktion von Variablen lässt sich durch folgende Ersetzung erzielen:

$$\hat{S}_2 = \hat{C}_1 \sin \Omega + \hat{S}_1 \cos \Omega, \tag{16a}$$

$$\hat{C}_2 = \hat{C}_1 \cos \Omega - \hat{S}_1 \sin \Omega, \tag{16b}$$

und

$$\sin \Omega = 2 \sin(\frac{\Omega}{2}) \cos(\frac{\Omega}{2}), \tag{17a}$$

$$\cos \Omega = 1 - 2 \sin^2(\frac{\Omega}{2}), \tag{17b}$$

Die Konstanten $\sin(\frac{\Omega}{2})$ und $\cos(\frac{\Omega}{2})$ können dabei als vorgegebene Parameter behandelt werden.

Der Wert für $\beta$ kann dabei aus jeder der folgenden Gleichungen ermittelt werden:

$$\beta = Y_j - (U \cdot S_j + V \cdot C_j) =$$
$$Y_j - [U \cdot (\hat{S}_{j-1} \cos(\frac{\Omega}{2}) + \hat{C}_{j-1} \sin(\frac{\Omega}{2})) + V \cdot (\hat{C}_{j-1} \cos(\frac{\Omega}{2}) - \hat{S}_{j-1} \sin(\frac{\Omega}{2}))}, \tag{18}$$
$$j \in \{2,3\}$$

Das Empfangen 201 einer Mehrzahl von aufeinanderfolgenden Werten eines Empfangssignals Y mit bekannter Abtastfrequenz $f_s$ als Reaktion auf ein Sendesignal mit bekannter Sendefrequenz $f_w$ lässt sich mit den Gleichungen (4) bis (6) beschreiben.

Das Bestimmen 202 von zwei Differenzwerten $\Delta Y1$, $\Delta Y2$ aus jeweils zwei aufeinanderfolgenden Werten von drei aufeinanderfolgenden Werte Y1, Y2, Y3 des Empfangssignals Y lässt sich durch das Gleichungssystem (11) beschreiben.

Das Bestimmen 203 eines Phasenrealteils U und eines Phasenimaginärteils V des Empfangssignals Y basierend auf einer linearen Beziehung zwischen dem Phasenrealteil U, dem Phasenimaginärteil V und den zwei Differenzwerten $\Delta Y1$, $\Delta Y2$ lässt sich durch Gleichungen (15a) und (15b) beschreiben.

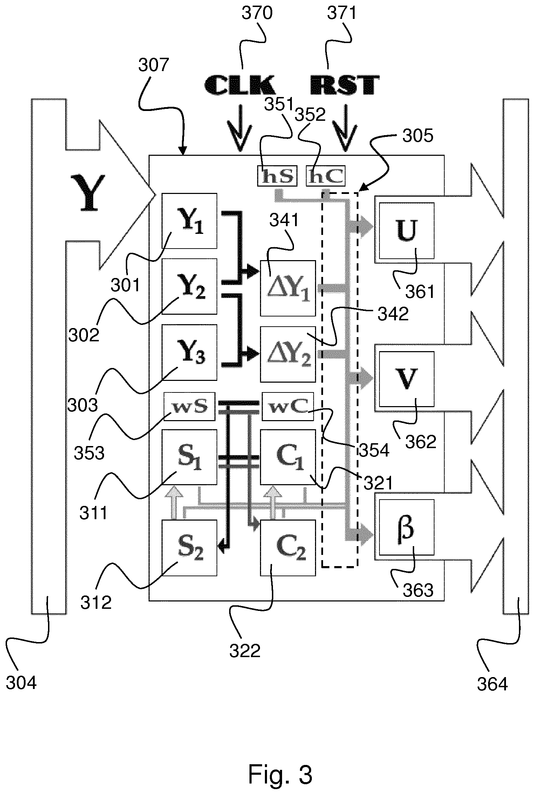

Fig. 3 zeigt eine schematische Darstellung eines Prozessors 300 zum Bestimmen einer Phase eines Empfangssignals gemäß einer ersten Ausführungsform.

Der Prozessor 300 umfasst ein erstes Eingangsregister 301, ein zweites Eingangsregister 302, ein drittes Eingangsregister 303, ein erstes internes Register 341, ein zweites internes Register 342, ein erstes Ausgangsregister 361, ein zweites Ausgangsregister 362, ein drittes Ausgangsregister 363, ein erstes Koeffizientenregister 321, ein zweites Koeffizientenregister 311, ein drittes Koeffizientenregister 322, ein viertes Koeffizientenregister 312, einen ersten Parameterspeicher 352 bzw. Parameterregister, einen zweiten Parameterspeicher 351 bzw. Parameterregister, einen dritten Parameterspeicher 354 bzw. Parameterregister, einen vierten Parameterspeicher 353 bzw. Parameterregister, eine Recheneinheit 305 und eine Instruktionseinheit 307. Der Prozessor 300 umfasst ferner einen Eingang für ein Taktsignal CLK 370 und einen Eingang für ein Reset-Signal RST 371. Der Prozessor 300 ist eingangsseitig mit einem Eingangsdatenbus 304 und ausgangsseitig mit einem Ausgangsdatenbus 364 gekoppelt. Die Kopplung der Eingänge und Ausgänge kann jedoch auch anderweitig realisiert sein. Die drei Eingangsregister 301, 302, 303 können als FIFO Speicher realisiert sein und in jedem Takt je einen neuen Wert des Empfangssignals Y aufnehmen und zugleich den ältesten aufgenommenen Wert löschen.

Der Prozessor 300 eignet sich zum Bestimmen einer Phase eines als Reaktion auf ein Sendesignal mit bekannter Sendefrequenz $f_w$ empfangenen Empfangssignals Y mit bekannter Abtastfrequenz $f_s$.

Die ersten 301, zweiten 302 und dritten 303 Eingangsregister dienen dazu, jeweils nacheinander drei aufeinanderfolgende Werte Y1, Y2, Y3 aus einer Mehrzahl von aufeinanderfolgenden Werten des Empfangssignals Y zu speichern, beispielsweise bei einer Mehrzahl von vier aufeinanderfolgenden Werten des Eingangssignals Y1, Y2, Y3, Y4 in einem ersten Takt die Werte Y1, Y2 und Y3 geladen werden, in einem zweiten Takt die Werte Y2, Y3 und Y4 geladen werden, wobei dann Y1 durch Y2 ersetzt wird, Y2 durch Y3 ersetzt wird und Y3 durch Y4 ersetzt wird, etc.

Das erste interne Register 341 dient dazu, einen ersten Differenzwert $\Delta Y1$ als Differenz des Inhalts Y2 des zweiten Eingangsregisters 302 und des Inhalts Y1 des ersten Eingangsregisters 301 zu speichern. Das zweite interne Register 342 dient dazu, einen zweiten Differenzwert $\Delta Y2$ als Differenz des Inhalts Y3 des dritten Eingangsregisters 303 und des Inhalts Y2 des zweiten Eingangsregisters 302 zu speichern.

Das erste Ausgangsregister 361 dient dazu, einen Phasenrealteil U des Empfangssignals Y bereitzustellen. Das zweite Ausgangsregister 362 dient dazu, einen Phasenimaginärteil V des Empfangssignals Y bereitzustellen.

Die Recheneinheit 305 dient dazu, den Phasenrealteil U und den Phasenimaginärteil V des Empfangssignals Y basierend auf einer linearen Beziehung zwischen dem Phasenrealteil U, dem Phasenimaginärteil V und den zwei Differenzwerten $\Delta Y1$, $\Delta Y2$ zu bestimmen, beispielsweise entsprechend dem in Fig. 2 beschriebenen Verfahren 200 oder entsprechend der weiter unten angegebenen Weise.

Die Recheneinheit 311, die hier nur als gestrichelter Kasten angedeutet ist, kann arithmetisch-logische Einheiten zum Ausführen arithmetischer Operationen aufweisen.

Sie kann Addierer, Multiplizierer und weitere Einheiten zum Ausführen von Rechenoperationen aufweisen.

Das dritte Ausgangsregister 363 dient dazu, einen Bias $\beta$ des Empfangssignals Y bereitzustellen.

Die Recheneinheit 305 ist ferner ausgelegt, den Bias $\beta$ des Empfangssignals Y basierend auf einer linearen Beziehung zwischen dem Phasenrealteil U, dem Phasenimaginärteil V, dem Bias $\beta$ und den drei aufeinanderfolgenden Werten Y1, Y2, Y3 des Empfangssignals Y zu bestimmen.

Die vier Koeffizientenregister 321, 311, 322, 312 dienen dazu, Fourier-Koeffizienten zu speichern, wobei die Fourier-Koeffizienten die lineare Beziehung zwischen dem Phasenrealteil U, dem Phasenimaginärteil V und den zwei Differenzwerten $\Delta Y1$, $\Delta Y2$ bestimmen.

Der erste Parameterspeicher 352 dient dazu, den Kosinus hC der Hälfte der bekannten Kreisfrequenz $\Omega = 2\pi(f_w/f_s)$ zu speichern. Der zweite Parameterspeicher 351 dient dazu, den Sinus hS der Hälfte der bekannten Kreisfrequenz $\Omega$ zu speichern. Der dritte Parameterspeicher 354 dient dazu, den Kosinus wC der bekannten Kreisfrequenz $\Omega$ zu speichern. Der vierte Parameterspeicher 353 dient dazu, den Sinus wS der bekannten Kreisfrequenz $\Omega$ zu speichern.

Die Recheneinheit 305 dient ferner dazu, den Phasenrealteil U und den Phasenimaginärteil V des Empfangssignals Y basierend auf den Inhalten C1, S1, C2, S2 der vier Koeffizientenregister 321, 311, 322, 312 und den Inhalten hC, hS, wC, wS der vier Parameterspeicher 352, 351, 354, 353 zu bestimmen.

Die Instruktionseinheit 307 ist ausgelegt, ansprechend auf ein Reset-Signal 371 das erste Koeffizientenregister 321 mit dem Inhalt hC des ersten Parameterspeichers 352 und das zweite Koeffizientenregister 311 mit dem Inhalt hS des zweiten Parameterspeichers 351 zu initialisieren. Die Instruktionseinheit 307 dient dazu, ansprechend auf ein Takt-Signal 370 das erste Koeffizientenregister 321 mit dem Inhalt C2 des dritten Koeffizientenregisters 322 und das zweite Koeffizientenregister 311 mit dem Inhalt S2 des vierten Koeffizientenregisters 312 zu erneuern.

Die Instruktionseinheit 307 ist ferner ausgelegt, ansprechend auf das Takt-Signal 370 das vierte Koeffizientenregister 312 mit dem Wert $C_1 wS + S_1 wC$ zu laden und das dritte Koeffizientenregister 322 mit dem Wert $C_1 wC - S_1 wS$ zu laden, wobei $wS$ den Inhalt des vierten Parameterspeichers 353, $wC$ den Inhalt des dritten Parameterspeichers 354, $C_1$ den Inhalt des ersten Koeffizientenregister 321, $S_1$ den Inhalt des zweiten Koeffizientenregister 311 angibt und $\Omega$ die bekannte Kreisfrequenz $\Omega = 2\pi(f_w/f_s)$ bezeichnet.

Die Recheneinheit 305 ist ausgelegt, den Phasenrealteil U als $\dfrac{\Delta Y_1 \cdot S_2 - \Delta Y_2 \cdot S_1}{4hS \cdot hS \cdot hC}$ und den Phasenimaginärteil V als $\dfrac{\Delta Y_1 \cdot C_2 - \Delta Y_2 \cdot C_1}{4hS \cdot hS \cdot hC}$ zu bestimmen, wobei $hS$ den Inhalt des zweiten Parameterspeichers 351, $hC$ den Inhalt des ersten Parameterspeichers 352, $C_2$ den Inhalt des dritten Koeffizientenregisters 322, $S_2$ den Inhalt des vierten Koeffizientenregister 312 angibt und $\Omega$ die bekannte Kreisfrequenz $\Omega = 2\pi(f_w/f_s)$ bezeichnet.

Die Recheneinheit 305 ist ferner ausgelegt, den Bias $\beta$ als $Y_2 - (U \cdot (S_1 hC + C_1 hS) + V \cdot (C_1 hC - S_1 hS))$ zu bestimmen, wobei U den Phasenrealteil, V den Phasenimaginärteil und $Y_2$ den Inhalt des zweiten Eingangsregisters 302 angibt. Der Bias kann aber auch nach einer anderen Formel entsprechend Gleichung (18) bestimmt werden.

Der Prozessor 300 kann in Hardware oder in Software realisiert sein. Der Prozessor 300 kann eine Operationseinheit auf einem Chip bilden oder als Chip realisiert sein. Der Prozessor 300 kann ein digitaler Signalprozessor oder ein Mikrocontroller sein. Der Prozessor 300 kann als FPGA, als integrierte Schaltung, als ASIC oder als Teil dieser Bauelemente realisiert sein. Der Prozessor 300 kann in einem Empfänger oder als Teil einer Empfängerschaltung realisiert sein, beispielsweise einem Empfänger 103 wie in Figur 1 dargestellt.

Die Funktionsweise des Prozessors 300 kann wie folgt beschrieben werden.

Nach Einschalten des Prozessors 300 bzw. nach Empfang des Reset-Signals RST 322 werden drei aufeinanderfolgende Werte $Y_0$, $Y_1$, Y3 des Eingangssignals Y von dem Eingangsdatenbus 304 in die drei Eingangsregister 301, 302, 303 geladen.

Das dritte Koeffizientenregister 322 und das vierte Koeffizientenregister 312 werden gelöscht. Das erste Koeffizientenregister 321 wird mit dem folgenden Wert initialisiert:

$$ hC = \cos\left(\frac{\Omega}{2}\right) \qquad (19a) $$

und das zweite Koeffizientenregister 311 wird mit dem folgenden Wert initialisiert:

$$ hS = \sin\left(\frac{\Omega}{2}\right). \qquad (19b) $$

In jedem Takt des Taktsignals 370 wird das dritte Koeffizientenregister 322 wird mit dem folgenden Wert geladen:

$$ C_1 wC - S_1 wS \qquad (20a) $$

und das vierte Koeffizientenregister 312 wird mit dem folgenden Wert geladen:

$$ C_1 wS + S_1 wC, \qquad (20b) $$

wobei gilt:

$$ wS = \sin\Omega, \qquad (21a) $$

$$ wC = \cos\Omega. \qquad (21b) $$

Das erste Ausgangsregister 361 wird mit dem folgenden Wert geladen:

$$ U = \frac{\Delta Y_1 \cdot S_2 - \Delta Y_2 \cdot S_1}{4hS \cdot hS \cdot hC}, \qquad (22a) $$

und das zweite Ausgangsregister 362 wird mit dem folgenden Wert geladen:

$$V = \frac{\Delta Y_1 \cdot C_2 - \Delta Y_2 \cdot C_1}{4hS \cdot hS \cdot hC}, \qquad (22b)$$

und der Wert

$$Y_2 - (U \cdot (S_1 hC + C_1 hS) + V \cdot (C_1 hC - S_1 hS)) \qquad (23)$$

wird in das dritte Ausgangsregister 363 geladen.

Dann wird das erste Koeffizientenregister 321 mit dem Inhalt $C_2$ des dritten Koeffizientenregisters 322 überschrieben und das zweite Koeffizientenregister 311 wird mit dem Inhalt $S_2$ des vierten Koeffizientenregisters 312 überschrieben. Das erste Eingangsregister 301 wird mit dem Inhalt $Y_2$ des zweiten Eingangsregisters 302 überschrieben, das zweite Eingangsregister 302 wird mit dem Inhalt $Y_3$ des dritten Eingangsregisters 303 überschrieben und ein neuer Eingangswert $Y_4$ wird von dem Eingangsdatenbus 304 in das dritte Eingangsregister 303 geladen. Die Werte $U$, $V$ und $\beta$ der drei Ausgangsregister 361, 362, 363 werden auf den Ausgangsdatenbus 364 übertragen.

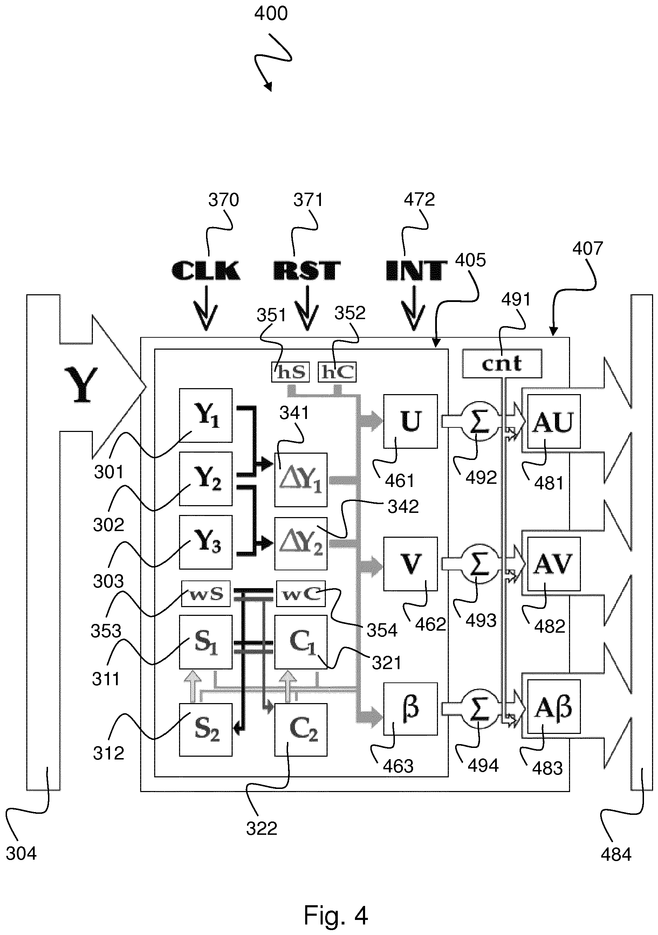

Fig. 4 zeigt eine schematische Darstellung eines Prozessors 400 zum Bestimmen einer Phase eines Empfangssignals gemäß einer zweiten Ausführungsform.

Der Prozessor 400 ist ähnlich aufgebaut wie der zu Fig. 3 beschriebene Prozessor 300. Der Prozessor 400 umfasst, entsprechend dem Prozessor 300, ein erstes Eingangsregister 301, ein zweites Eingangsregister 302, ein drittes Eingangsregister 303, ein erstes internes Register 341, ein zweites internes Register 342, ein erstes Ausgangsregister 461, ein zweites Ausgangsregister 462, ein drittes Ausgangsregister 463, ein erstes Koeffizientenregister 321, ein zweites Koeffizientenregister 311, ein drittes Koeffizientenregister 322, ein viertes Koeffizientenregister 312, einen ersten Parameterspeicher 352, einen zweiten Parameterspeicher 351, einen dritten Parameterspeicher 354, einen vierten Parameterspeicher 353, eine Recheneinheit 405 und eine Instruktionseinheit 407. Der Prozessor 400 umfasst ferner einen Eingang für ein Taktsignal CLK 370 und einen Eingang für ein Reset-Signal RST 471. Der Prozessor 400 ist eingangsseitig mit einem Eingangsdatenbus 304 und ausgangsseitig mit einem Ausgangsdatenbus 464 gekoppelt. Bezüglich der Funktionsweise der hier angegebenen Einheiten wird Bezug genommen auf die Beschreibung zu Fig. 3, wobei die Recheneinheit aufgrund der zusätzlichen Funktionsweise mit dem Bezugszeichen 405 und die Instruktionseinheit aufgrund der zusätzlichen Funktionsweise mit dem Bezugszeichen 407 bezeichnet ist.

Zusätzlich zu dem Prozessor 300 umfasst der Prozessor 400 ferner ein viertes Ausgangsregister bzw. ein erstes Hilfsregister 481, ein fünftes Ausgangsregister bzw. ein zweites Hilfsregister 482, ein sechstes Ausgangsregister bzw. ein drittes Hilfsregister 483, drei Summationsglieder 492, 493, 494, einen Zähler 491 und einen Eingang für ein Interrupt-Signal INT 472.

Der Zähler 491 wird mit jeder Erneuerung der drei Eingangsregister 301, 302, 303 abhängig von dem Taktsignal 370 inkrementiert.

Die Recheneinheit 405 ist ferner ausgelegt, den Phasenrealteil U als $\Delta Y_1 S_2 - \Delta Y_2 S_1$ und den Phasenimaginärteil V als $\Delta Y_1 C_2 - \Delta Y_2 C_1$ zu bestimmen, den Phasenrealteil U zu dem ersten Hilfsregister 481 hinzuzuaddieren, und den Phasenimaginärteil V zu dem zweiten Hilfsregister 482 hinzuzuaddieren.

Die Instruktionseinheit 407 ist ferner ausgelegt, ansprechend auf das Interrupt-Signal die Werte AU, AV der beiden Hilfsregister 481, 482 geteilt durch den Wert $2 \cdot wS \cdot hS = 4hS \cdot hS \cdot hC$ und geteilt durch einen Wert cnt des Zählers 491 auszugeben. Dabei gibt $\Delta Y_1$ den Inhalt des ersten internen Registers 341, $\Delta Y_2$ den Inhalt des zweiten internen Registers 342, $C_2$ den Inhalt des dritten Koeffizientenregisters 322, $S_2$ den Inhalt des vierten Koeffizientenregister 312, $hS$ den Inhalt des zweiten Parameterspeichers 351 und $hC$ den Inhalt des ersten Parameterspeichers 352 an. $\Omega$ bezeichnet die bekannte Kreisfrequenz $\Omega = 2\pi(f_w/f_s)$.

Der Prozessor 400 kann in Hardware oder in Software realisiert sein. Der Prozessor 400 kann eine Operationseinheit auf einem Chip bilden oder als Chip realisiert sein. Der Prozessor 400 kann ein digitaler Signalprozessor oder ein Mikrocontroller sein. Der Prozessor 400 kann als FPGA, als integrierte Schaltung, als ASIC oder als Teil dieser Bauelemente realisiert sein. Der Prozessor 400 kann in einem Empfänger oder als Teil einer Empfängerschaltung realisiert sein, beispielsweise einem Empfänger 103 wie in Figur 1 dargestellt.

Die Funktionsweise des Prozessors 400 kann wie folgt beschrieben werden.

Nach Einschalten des Prozessors 400 bzw. nach Empfang des Reset-Signals RST 322 werden drei aufeinanderfolgende Werte $Y_0$, $Y_1$, $Y_3$ des Eingangssignals Y von dem Eingangsdatenbus 304 in die drei Eingangsregister 301, 302, 303 geladen.

Das dritte Koeffizientenregister 322 und das vierte Koeffizientenregister 312 werden gelöscht. Das erste Koeffizientenregister 321 wird mit dem folgenden Wert initialisiert:

$$hC = \cos(\frac{\Omega}{2}) \qquad (24a)$$

und das zweite Koeffizientenregister 311 wird mit dem folgenden Wert initialisiert:

$$hS = \sin(\frac{\Omega}{2}) . \qquad (24b)$$

In jedem Takt des Taktsignals 370 wird das dritte Koeffizientenregister 322 wird mit dem folgenden Wert geladen:

$$C_1 wC - S_1 wS \qquad (25a)$$

und das vierte Koeffizientenregister 312 wird mit dem folgenden Wert geladen:

$$C_1 wS + S_1 wC , \qquad (25b)$$

wobei gilt:

$$wS = \sin \Omega , \qquad (26a)$$

$$wC = \cos \Omega . \qquad (26b)$$

Das erste Ausgangsregister 461 wird mit dem folgenden Wert geladen:

$$U = \Delta Y_1 \cdot S_2 - \Delta Y_2 \cdot S_1 , \qquad (27a)$$

der auch zu dem vierten Ausgangsregister 481 hinzuaddiert wird, wozu das erste Summationsglied 492 verwendet wird. Das zweite Ausgangsregister 362 wird mit dem folgenden Wert geladen:

$$V = \Delta Y_1 \cdot C_2 - \Delta Y_2 \cdot C_1 , \qquad (27b)$$

der auch zu dem fünften Ausgangsregister 482 hinzuaddiert wird, wozu das zweite Summationsglied 493 verwendet wird.
Der Wert

$$Y_2 - \frac{(U \cdot (S_1 wC + C_1 wS) + V \cdot (C_1 wC - S_1 wS))}{4 \cdot hS \cdot hS \cdot hC} \qquad (28)$$

wird in das dritte Ausgangsregister 463 geladen.
Dann wird das erste Koeffizientenregister 321 mit dem Inhalt $C_2$ des dritten Koeffizientenregisters 322 überschrieben und das zweite Koeffizientenregister 311 wird mit dem Inhalt $S_2$ des vierten Koeffizientenregisters 312 überschrieben. Der Zähler 491 wird inkrementiert. Das erste Eingangsregister 301 wird mit dem Inhalt $Y_2$ des zweiten Eingangsregisters 302 überschrieben, das zweite Eingangsregister 302 wird mit dem Inhalt $Y_3$ des dritten Eingangsregisters 303 überschrieben und ein neuer Eingangswert $Y_4$ wird von dem Eingangsdatenbus 304 in das dritte Eingangsregister 303 geladen.
Sobald ein Interrupt anliegt, d.h. das Interrupt-Signal 472 einen Interrupt signalisiert, wird der Inhalt AU des vierten Ausgangsregisters 481 und der Inhalt AV des fünften Ausgangsregisters 482 durch den Wert *2wShS(=4hShShC)*

geteilt und ihre Werte und auch der Wert $\beta$ des dritten Ausgangsregisters 463, jeweils durch den Wert cnt des Zählers 491 geteilt, werden an den Ausgangsdatenbus 484 übertragen.

Danach wird das Reset-Signal 371 gesendet.

Sowohl der Prozessor 300 gemäß der Beschreibung zu Figur 3 als auch der Prozessor 400 gemäß der Beschreibung zu Figur 4 eignen sich dazu, das in Fig. 2 beschriebene Verfahren 200 zu implementieren.

Ein Aspekt der Erfindung umfasst auch ein Computerprogrammprodukt, das direkt in den internen Speicher eines digitalen Computers geladen werden kann und Softwarecodeabschnitte umfasst, mit denen das zu Fig. 2 beschriebene Verfahren 200 ausgeführt werden kann, wenn das Produkt auf einem Computer läuft. Das Computerprogrammprodukt kann auf einem computergeeigneten Medium gespeichert sein und folgendes umfassen: computerlesbare Programmmittel, die einen Computer veranlassen eine Mehrzahl von aufeinanderfolgenden Werten eines Empfangssignals Y mit bekannter Abtastfrequenz $f_s$ als Reaktion auf ein Sendesignal mit bekannter Sendefrequenz $f_w$ zu empfangen 201; zwei Differenzwerte $\Delta Y1$, $\Delta Y2$ aus jeweils zwei aufeinanderfolgenden Werten von drei aufeinanderfolgenden Werte Y1, Y2, Y3 des Empfangssignals Y zu bestimmen 202; und einen Phasenrealteil U und einen Phasenimaginärteil V des Empfangssignals Y basierend auf einer linearen Beziehung zwischen dem Phasenrealteil U, dem Phasenimaginärteil V und den zwei Differenzwerten $\Delta Y1$, $\Delta Y2$ zu bestimmen 203.

Der Computer kann ein PC sein, beispielsweise ein PC eines Computernetzwerks. Der Computer kann als ein Chip, ein ASIC, ein Mikroprozessor, ein Signalprozessor oder allgemein als ein Prozessor realisiert sein und beispielsweise als Prozessor wie in den Figuren 3 bis 5 beschrieben, implementiert sein.

Es ist selbstverständlich, dass die Merkmale der verschiedenen beispielhaft hierin beschriebenen Ausführungsformen miteinander kombiniert werden können, außer wenn spezifisch anderweitig angegeben. Wie in der Beschreibung und den Zeichnungen dargestellt müssen einzelne Elemente, die in Verbindung stehend dargestellt wurden, nicht direkt miteinander in Verbindung stehen; Zwischenelemente können zwischen den verbundenen Elementen vorgesehen sein. Ferner ist es selbstverständlich, dass Ausführungsformen der Erfindung in einzelnen Schaltungen, teilweise integrierten Schaltungen oder vollständig integrierten Schaltungen oder Programmiermitteln implementiert sein können. Der Begriff "beispielsweise" ist lediglich als ein Beispiel gemeint und nicht als das Beste oder Optimale. Es wurden bestimmte Ausführungsformen hierin veranschaulicht und beschrieben, doch für den Fachmann ist es offensichtlich, dass eine Vielzahl von alternativen und/oder gleichartigen Implementierungen anstelle der gezeigten und beschriebenen Ausführungsformen verwirklicht werden können, ohne vom Konzept der vorliegenden Erfindung, das durch die angehängten Ansprüche definiert ist abzuweichen.

**Bezugszeichenliste**

| | |
|---|---|
| 100: | System 100 zur Messung von Phasenbeziehungen akustischer Wellen in einem Gefäß |
| 101: | Sender |
| 102: | Gefäß |
| 103: | Empfänger |
| 104: | Ultraschallwelle |
| 105: | Eingang |
| 107: | Ausgang |
| | |
| 200: | Phasendetektionsverfahren 200 |
| 201: | 1. Verfahrensschritt: Empfangen |
| 202: | 2. Verfahrensschritt: Bestimmen |
| 203: | 3. Verfahrensschritt: Bestimmen |
| | |
| 300: | Prozessor, geeignet zum Bestimmen einer Phase eines Empfangssignals |
| 301: | erstes Eingangsregister |
| 302: | zweites Eingangsregister |
| 303: | drittes Eingangsregister |
| 304: | Eingangsdatenbus |
| 305: | Recheneinheit |
| 307: | Instruktionseinheit |
| 311: | zweites Koeffizientenregister |
| 312: | viertes Koeffizientenregister |
| 321: | erstes Koeffizientenregister |
| 322: | drittes Koeffizientenregister |

341: erstes internes Register
342: zweites internes Register
351: zweiter Parameterspeicher
352: erster Parameterspeicher
353: vierter Parameterspeicher
354: dritter Parameterspeicher
361: erstes Ausgangsregister
362: zweites Ausgangsregister
363: drittes Ausgangsregister
364: Ausgangsdatenbus
370: Takt Signal
371: Reset-Signal

400: Prozessor, geeignet zum Bestimmen einer Phase eines Empfangssignals
405: Recheneinheit
407: Instruktionseinheit
484: Ausgangsdatenbus
472: Interrupt-Signal
481: viertes Ausgangsregister bzw. erstes Hilfsregister
482: fünftes Ausgangsregister bzw. zweites Hilfsregister
483: sechstes Ausgangsregister bzw. drittes Hilfsregister
491: Zähler
492: erstes Summationsglied
493: zweites Summationsglied
494: drittes Summationsglied

**Patentansprüche**

1. Ein Phasendetektionsverfahren (200), mit folgenden Schritten:

   Empfangen (201) einer Mehrzahl von aufeinanderfolgenden Werten eines Empfangssignals (Y) mit bekannter Abtastfrequenz $f_s$ als Reaktion auf ein Sendesignal mit bekannter Sendefrequenz $f_w$;
   Bestimmen (202) von zwei Differenzwerten ($\Delta$Y1, $\Delta$Y2) aus jeweils zwei aufeinanderfolgenden Werten von drei aufeinanderfolgenden Werten (Y1, Y2, Y3) des Empfangssignals (Y); und **gekennzeichnet durch** Bestimmen (203) eines Phasenrealteils (U) und eines Phasenimaginärteils (V) des Empfangssignals (Y) basierend auf einer linearen Beziehung zwischen dem Phasenrealteil (U), dem Phasenimaginärteil (V) und den zwei Differenzwerten ($\Delta$Y1, $\Delta$Y2).

2. Phasendetektionsverfahren (200) nach Anspruch 1,
   wobei die lineare Beziehung zwischen dem Phasenrealteil (U), dem Phasenimaginärteil (V) und den zwei Differenzwerten ($\Delta$Y1, $\Delta$Y2) durch ein zweidimensionales lineares Gleichungssystem darstellbar ist basierend auf den zwei Differenzwerten ($\Delta$Y1, $\Delta$Y2) als Eingangsvariablen und dem Phasenrealteil (U) und dem Phasenimaginärteil (V) als Ausgangsvariablen.

3. Phasendetektionsverfahren (200) nach Anspruch 2,
   wobei das lineare Gleichungssystem durch Gewichtung der Eingangsvariablen mit Fourier-Koeffizienten, die auf einer bekannten Kreisfrequenz $\Omega$ basieren, gelöst wird,
   wobei die bekannte Kreisfrequenz $\Omega$ von der Sendefrequenz $f_w$ und der Abtastfrequenz $f_s$ abhängt.

4. Phasendetektionsverfahren (200) nach Anspruch 3,
   wobei die bekannte Kreisfrequenz $\Omega$ der folgenden Beziehung genügt: $\Omega = 2\pi(f_w/f_s)$.

5. Phasendetektionsverfahren (200) nach Anspruch 3 oder 4, mit:
   Bestimmen der Fourier-Koeffizienten abhängig von der bekannten Kreisfrequenz $\Omega$ vor dem Bestimmen des Phasenrealteils (U) und des Phasenimaginärteils (V) des Empfangssignals (Y).

6. Phasendetektionsverfahren (200) nach einem der vorstehenden Ansprüche, mit:

Bestimmen eines Bias ($\beta$) des Empfangssignals (Y) basierend auf einer linearen Beziehung zwischen dem Phasenrealteil (U), dem Phasenimaginärteil (V), dem Bias ($\beta$) und den drei aufeinanderfolgenden Werten (Y1, Y2, Y3) des Empfangssignals (Y).

7. Prozessor (300, 400) zum Bestimmen einer Phase eines als Reaktion auf ein Sendesignal mit bekannter Sendefrequenz $f_w$ empfangenen Empfangssignals (Y) mit bekannter Abtastfrequenz $f_s$, **gekennzeichnet durch**:

ein erstes Eingangsregister (301), ein zweites Eingangsregister (302) und ein drittes Eingangsregister (303), die ausgelegt sind, jeweils nacheinander drei aufeinanderfolgende Werte (Y1, Y2, Y3) aus einer Mehrzahl von aufeinanderfolgenden Werten des Empfangssignals (Y) zu speichern;
ein erstes internes Register (341) und ein zweites internes Register (342), die ausgelegt sind, einen ersten Differenzwert ($\Delta$Y1) als Differenz des Inhalts (Y2) des zweiten Eingangsregisters (302) und des Inhalts (Y1) des ersten Eingangsregisters (301) und einen zweiten Differenzwert ($\Delta$Y2) als Differenz des Inhalts (Y3) des dritten Eingangsregisters (303) und des Inhalts (Y2) des zweiten Eingangsregisters (302) zu speichern;
ein erstes Ausgangsregister (361, 481) und ein zweites Ausgangsregister (362, 482), die ausgelegt sind, einen Phasenrealteil (U) und einen Phasenimaginärteil (V) des Empfangssignals (Y) bereitzustellen; und
eine Recheneinheit (305, 405), die ausgelegt ist, den Phasenrealteil (U) und den Phasenimaginärteil (V) des Empfangssignals (Y) basierend auf einer linearen Beziehung zwischen dem Phasenrealteil (U), dem Phasenimaginärteil (V) und den zwei Differenzwerten ($\Delta$Y1, $\Delta$Y2) zu bestimmen.

8. Prozessor (300, 400) nach Anspruch 7, mit
einem dritten Ausgangsregister (363, 483), das ausgelegt ist, einen Bias ($\beta$) des Empfangssignals (Y) bereitzustellen,
wobei die Recheneinheit (305, 405) ausgelegt ist, den Bias ($\beta$) des Empfangssignals (Y) basierend auf einer linearen Beziehung zwischen dem Phasenrealteil (U), dem Phasenimaginärteil (V), dem Bias ($\beta$) und den drei aufeinanderfolgenden Werten (Y1, Y2, Y3) des Empfangssignals (Y) zu bestimmen.

9. Der Prozessor (300, 400) nach Anspruch 8, mit
einem ersten Koeffizientenregister (321), einem zweiten Koeffizientenregister (311), einem dritten Koeffizientenregister (322) und einem vierten Koeffizientenregister (312), die ausgelegt sind, Fourier-Koeffizienten zu speichern,
wobei die Fourier-Koeffizienten die lineare Beziehung zwischen dem Phasenrealteil (U), dem Phasenimaginärteil (V) und den zwei Differenzwerten ($\Delta$Y1, $\Delta$Y2) bestimmen.

10. Prozessor (300, 400) nach Anspruch 9, mit
einem ersten Parameterspeicher (352), der ausgelegt ist den Kosinus (hC) der Hälfte einer bekannten Kreisfrequenz $\Omega$, die von der Sendefrequenz $f_w$ und der Abtastfrequenz $f_s$ abhängt, zu speichern;
einem zweiten Parameterspeicher (351), der ausgelegt ist den Sinus (hS) der Hälfte der bekannten Kreisfrequenz $\Omega$ zu speichern;
einem dritten Parameterspeicher (354), der ausgelegt ist den Kosinus (wC) der bekannten Kreisfrequenz $\Omega$ zu speichern; und
einem vierten Parameterspeicher (353), der ausgelegt ist den Sinus (wS) der bekannten Kreisfrequenz $\Omega$ zu speichern.

11. Prozessor (300, 400) nach Anspruch 10,
wobei die bekannte Kreisfrequenz $\Omega$ der folgenden Beziehung genügt: $\Omega = 2\pi(f_w/f_s)$.

12. Prozessor (300, 400) nach Anspruch 10 oder 11,
wobei die Recheneinheit (305, 405) ausgelegt ist, den Phasenrealteil (U) und den Phasenimaginärteil (V) des Empfangssignals (Y) basierend auf den Inhalten (C1, S1, C2, S2) der vier Koeffizientenregister (321, 311, 322, 312) und den Inhalten (hC, hS, wC, wS) der vier Parameterspeicher (352, 351, 354, 353) zu bestimmen.

13. Prozessor (300, 400) nach Anspruch 12, mit
einer Instruktionseinheit (307, 407), die ausgelegt ist,
ansprechend auf ein Reset-Signal (371) das erste Koeffizientenregister (321) mit dem Inhalt (hC) des ersten Parameterspeichers (352) und das zweite Koeffizientenregister (311) mit dem Inhalt (hS) des zweiten Parameterspeichers (351) zu initialisieren; und
ansprechend auf ein Takt-Signal (370) das erste Koeffizientenregister (321) mit dem Inhalt (C2) des dritten Koeffizientenregisters (322) und das zweite Koeffizientenregister (311) mit dem Inhalt (S2) des vierten Koeffizientenregisters (312) zu erneuern;

wobei die Instruktionseinheit (307, 407) ausgelegt ist,
ansprechend auf das Takt-Signal (370) das vierte Koeffizientenregister (312) mit dem Wert $C_1wS + S_1wC$ zu laden und das dritte Koeffizientenregister (322) mit dem Wert $C_1wC-S_1wS$ zu laden,

wobei $wS$ den Inhalt des vierten Parameterspeichers (353), $wC$ den Inhalt des dritten Parameterspeichers (354), $C_1$ den Inhalt des ersten Koeffizientenregister (321), $S_1$ den Inhalt des zweiten Koeffizientenregister (311) angibt und $\Omega$ die bekannte Kreisfrequenz $\Omega=2\pi(f_w/f_s)$ bezeichnet;

wobei die Recheneinheit (305, 405) ausgelegt ist, den Phasenrealteil (U) als $\dfrac{\Delta Y_1 \cdot S_2 - \Delta Y_2 \cdot S_1}{4hS \cdot hS \cdot hC}$ und den Phasenimaginärteil (V) als $\dfrac{\Delta Y_1 \cdot C_2 - \Delta Y_2 \cdot C_1}{4hS \cdot hS \cdot hC}$ zu bestimmen,

wobei $hS$ den Inhalt des zweiten Parameterspeichers (351), $hC$ den Inhalt des ersten Parameterspeichers (352), $C_2$ den Inhalt des dritten Koeffizientenregisters (322), $S_2$ den Inhalt des vierten Koeffizientenregister (312) angibt und $\Omega$ die bekannte Kreisfrequenz $\Omega=2\pi(f_w/f_s)$ bezeichnet.

14. Prozessor (300, 400) nach Anspruch 13,
wobei die Recheneinheit (305, 405) ausgelegt ist, den Bias ($\beta$) als $Y_2+(U\cdot(S_1hC+C_1hS)+V\cdot(C_1hC-S_1hS))$ zu bestimmen,
wobei U den Phasenrealteil, V den Phasenimaginärteil und $Y_2$ den Inhalt des zweiten Eingangsregisters (302) angibt.

15. Prozessor (400) nach Anspruch 12, mit
einem ersten Hilfsregister (481);
einem zweiten Hilfsregister (482); und
einem Zähler (491), der mit jeder Erneuerung der drei Eingangsregister (301, 302, 303) abhängig von dem Taktsignal (370) inkrementiert wird,
wobei die Recheneinheit (405) ausgelegt ist, den Phasenrealteil (U) als $\Delta Y_1 S_2 - \Delta Y_2 S_1$ und den Phasenimaginärteil (V) als $\Delta Y_1 C_2 - \Delta Y_2 C_1$ zu bestimmen, den Phasenrealteil (U) zu dem ersten Hilfsregister (481) hinzuzuaddieren, und den Phasenimaginärteil (V) zu dem zweiten Hilfsregister (482) hinzuzuaddieren,
wobei die Instruktionseinheit (407) ausgelegt ist,
ansprechend auf ein Interrupt-Signal (472) die Werte (AU, AV) der beiden Hilfsregister (481, 482) geteilt durch den Wert $2\cdot wS\cdot hS = 4hS\cdot hS\cdot hC$ und geteilt durch einen Wert (cnt) des Zählers (491) auszugeben,
wobei $\Delta Y_1$ den Inhalt des ersten internen Registers (341), $\Delta Y_2$ den Inhalt des zweiten internen Registers (342), $C_2$ den Inhalt des dritten Koeffizientenregisters (322), $S_2$ den Inhalt des vierten Koeffizientenregister (312), $hS$ den Inhalt des zweiten Parameterspeichers (351) und $hC$ den Inhalt des ersten Parameterspeichers (352) angibt, und $\Omega$ die bekannte Kreisfrequenz $\Omega=2\pi(f_w/f_s)$ bezeichnet.

**Claims**

1. A phase detection method (200), comprising the following steps:

   receiving (201) a plurality of consecutive values of a receiving signal (Y) with a known sampling frequency $f_s$ as a reaction to a transmitting signal with a known transmitting frequency $f_w$;
   determining (202) two differential values ($\Delta Y1$, $\Delta Y2$), each coming from two consecutive values out of three consecutive values (Y1, Y2, Y3) of the receiving signal (Y); and
   **characterized by**
   determining (203) a phase real part (U) and a phase imaginary part (V) of the receiving signal (Y) based on a linear relation between the phase real part (U), the phase imaginary part (V) and the two differential values ($\Delta Y1$, $\Delta Y2$).

2. The phase detection method (200) according to claim 1,
   wherein the linear relation between the phase real part (U), the phase imaginary part (V) and the two differential values ($\Delta Y1$, $\Delta Y2$) can be represented by a two-dimensional linear system of equations based on the two differential values ($\Delta Y1$, $\Delta Y2$) as input variables and the phase real part (U) and the phase imaginary part (V) as output variables.

3. The phase detection method (200) according to claim 2,

wherein the linear system of equations is solved by weighting of the input variables with Fourier Coefficients which are based on a known circular frequency $\Omega$, wherein said known circular frequency $\Omega$ depends on the transmitting frequency $f_w$ and the sampling frequency $f_s$.

4. The phase detection method (200) according to claim 3,
   wherein the known circular frequency $\Omega$ satisfies the following condition:

$$\Omega = 2\pi(f_w/f_s).$$

5. The phase detection method (200) according to claim 3 or 4, comprising:
   determining the Fourier Coefficients in dependence of the known circular frequency $\Omega$ before determining the phase real part (U) and the phase imaginary part (V) of the receiving signal (Y).

6. The phase detection method (200) according to any one of the preceding claims, comprising:
   determining a bias ($\beta$) of the receiving signal (Y) based on a linear relation between the phase real part (U), the phase imaginary part (V), the bias ($\beta$) and the three consecutive values (Y1, Y2, Y3) of the receiving signal (Y).

7. A processor (300, 400) for determining a phase of a receiving signal (Y) being received as a reaction to a transmitting signal with a known transmitting frequency $f_w$, said receiving signal (Y) having a known sampling frequency $f_s$, **characterized by**
   a first input register (301), a second input register (302) and a third input register (303), which are configured for storing three consecutive values (Y1, Y2, Y3) from a plurality of consecutive values of the receiving signal (Y) one after the other;
   a first internal register (341) and a second internal register (342), which are configured for storing a first differential value ($\Delta$Y1) as a difference of the content (Y2) of the second input register (302) and the content (Y1) of the first input register (301) and for storing a second differential value ($\Delta$Y2) as a difference of the content (Y3) of the third input register (303) and the content (Y2) of the second input register (302);
   a first output register (361, 481) and a second output register (362, 482), which are configured for providing a phase real part (U) and a phase imaginary part (V) of the receiving signal (Y); and
   a computing unit (305, 405), which is configured for determining the phase real part (U) and the phase imaginary part (V) of the receiving signal (Y) based on a linear relation between the phase real part (U), the phase imaginary part (V) and the two differential values ($\Delta$Y1, $\Delta$Y2).

8. The processor (300, 400) according to claim 7, comprising:

   a third output register (363, 483), which is configured for providing a bias ($\beta$) of the receiving signal (Y),
   wherein the computing unit (305, 405) is configured for determining the bias ($\beta$) of the receiving signal (Y) based on a linear relation between the phase real part (U), the phase imaginary part (V), the bias ($\beta$) and the three consecutive values (Y1, Y2, Y3) of the receiving signal (Y).

9. The processor (300, 400) according to claim 8, comprising:
   a first coefficient register (321), a second coefficient register (311), a third coefficient register (322) and a fourth coefficient register (312), which are configured for storing Fourier Coefficients, wherein said Fourier Coefficients determine the linear relation between the phase real part (U), the phase imaginary part (V) and the two differential values ($\Delta$Y1, $\Delta$Y2).

10. The processor (300, 400) according to claim 9, comprising:

    a first parameter memory (352), which is configured for storing the cosine (hC) of the half of a known circular frequency $\Omega$, which depends on the transmitting frequency $f_w$ and the sampling frequency $f_s$;
    a second parameter memory (351), which is configured for storing the sine (hS) of the half of the known circular frequency $\Omega$;
    a third parameter memory (354), which is configured for storing the cosine (wC) of the known circular frequency $\Omega$; and
    a fourth parameter memory (353), which is configured for storing the sine (wS) of the known circular frequency $\Omega$.

**11.** The processor (300, 400) according to claim 10,
wherein the known circular frequency $\Omega$ satisfies the following condition:

$$\Omega = 2\pi(f_w/f_s).$$

**12.** The processor (300, 400) according to claim 10 or 11,
wherein the computing unit (305, 405) is configured for determining the phase real part (U) and the phase imaginary part (V) of the receiving signal (Y) based on the contents (C1, S1, C2, S2) of the four coefficient registers (321, 311, 322, 312) and the contents (hC, hS, wC, wS) of the four parameter memories (352, 351, 354, 353).

**13.** The processor (300, 400) according to claim 12, comprising:

an instruction unit (307, 407), which is configured
for initializing the first coefficient register (321) with the content (hC) of the first parameter memory (352) and for initializing the second coefficient register (311) with the content (hS) of the second parameter memory (351) in response to a reset signal (371); and
for renewing the first coefficient register (321) with the content (C2) of the third coefficient register (322) and for renewing the second coefficient register (311) with the content (S2) of the fourth coefficient register (312) in response to a clock signal (370);
wherein the instruction unit (307, 407) is configured
for loading the fourth coefficient register (312) with the value $C_1 wS + S_1 wC$ and for loading the third coefficient register (322) with the value $C_1 wC - S_1 wS$ in response to the clock signal (370),
wherein wS denotes the content of the fourth parameter memory (353), wC denotes the content of the third parameter memory (354), $C_1$ denotes the content of the first coefficient register (321), $S_1$ denotes the content of the second coefficient register (311) and $\Omega$ denotes the known circular frequency $\Omega = 2\pi(f_w/f_s)$;
wherein the computing unit (305, 405) is configured for determining the phase real part (U) as

$$\frac{\Delta Y_1 \cdot S_2 - \Delta Y_2 \cdot S_1}{4hS \cdot hS \cdot hC} \quad \text{and the phase imaginary part (V) as} \quad \frac{\Delta Y_1 \cdot C_2 - \Delta Y_2 \cdot C_1}{4hS \cdot hS \cdot hC},$$

wherein hS denotes the content of the second parameter memory (351), hC denotes the content of the first parameter memory (352), $C_2$ denotes the content of the third coefficient register (322), $S_2$ denotes the content of the fourth coefficient register (312) and $\Omega$ denotes the known circular frequency

$$\Omega = 2\pi(f_w/f_w).$$

**14.** The processor (300, 400) according to claim 13,
wherein the computing unit (305, 405) is configured for determining the bias ($\beta$) as $Y_2 - (U \cdot (S_1 hC + C_1 hS) + V \cdot (C_1 hC - S_1 hS))$,
wherein U denotes the phase real part, V denotes the phase imaginary part and $Y_2$ denotes the content of the second input register (302).

**15.** The processor (400) according to claim 12, comprising
a first auxiliary register (481);
a second auxiliary register (482); and
a counter (491), which is incremented at every renewal of the three input registers (301, 302, 303) depending on the clock signal (370),
wherein the computing unit (405) is configured for determining the phase real part (U) as $\Delta Y_1 S_2 - \Delta Y_2 S_1$ and the phase imaginary part (V) as $\Delta Y_2 C_2 - \Delta Y_2 C_1$, for adding the phase real part (U) to the first auxiliary register (481) and for adding the phase imaginary part (V) to the second auxiliary register (482),
wherein the instruction unit (407) is configured
for outputting the values (AU, AV) of the two auxiliary registers (481, 482) divided by the value $2 \cdot wS \cdot hS = 4hS \cdot hS \cdot hC$ and divided by a value (cnt) of the counter (491) in response to an interruption signal,
wherein $\Delta Y_1$ denotes the content of the first internal register (341), $\Delta Y_2$ denotes the content of the second internal register (342), $C_2$ denotes the content of the third coefficient register (322), $S_2$ denotes the content of the fourth coefficient register (312), hS denotes the content of the second parameter memory (351) and hC denotes the content of the first parameter memory (352) and $\Omega$ denotes the known circular frequency $\Omega=2\pi(f_w/f_s)$.

**Revendications**

1. Procédé de détection de phase (200), comprenant les étapes suivantes :

   réception (201) d'une pluralité de valeurs consécutives d'un signal de réception (Y) avec une fréquence d'échantillonnage $f_s$ connue en réaction à un signal de transmission avec une fréquence de transmission $f_w$ connue ;
   détermination (202) de deux valeurs différentielles ($\Delta Y1$, $\Delta Y2$), chacune venant de deux valeurs consécutives de trois valeurs consécutives (Y1, Y2, Y3) du signal de réception (Y) ; et **caractérisé par**
   une détermination (203) d'une partie réelle de phase (U) et d'une partie imaginaire de phase (V) du signal de réception (Y) sur la base d'une relation linéaire entre la partie réelle de phase (U), la partie imaginaire de phase (V) et les deux valeurs différentielles ($\Delta Y1$, $\Delta Y2$).

2. Procédé de détection de phase (200) selon la revendication 1,
   dans lequel la relation linéaire entre la partie réelle de phase (U), la partie imaginaire de phase (V) et les deux valeurs différentielles ($\Delta Y1$, $\Delta Y2$) peut être représentée par un système d'équation linéaire en deux dimensions sur la base desdites deux valeurs différentielles ($\Delta Y1$, $\Delta Y2$) comme variables d'entrée et sur la base de la partie réelle de phase (U) et sur la base de la partie imaginaire de phase (V) comme variables de sortie.

3. Procédé de détection de phase (200) selon la revendication 2,
   dans lequel le système d'équation linéaire est résolu par une pondération des variables d'entrée avec des coefficients de Fourier qui sont basés sur une fréquence angulaire $\Omega$ connue, ladite fréquence angulaire $\Omega$ connue dépendant de la fréquence de transmission $f_w$ et de la fréquence d'échantillonnage $f_s$.

4. Procédé de détection de phase (200) selon la revendication 3,
   dans lequel la fréquence angulaire $\Omega$ connue satisfait la condition suivante :

$$\Omega=2\pi(f_w/f_s).$$

5. Procédé de détection de phase (200) selon la revendication 3 ou 4, comprenant l'étape suivante :
   détermination des coefficients de Fourier dépendant de la fréquence angulaire $\Omega$ connue avant la détermination de la partie réelle de phase (U) et de la partie imaginaire de phase (V) du signal de réception (Y).

6. Procédé de détection de phase (200) selon l'une quelconque des revendications précédentes, comprenant l'étape suivante :
   détermination d'un biais ($\beta$) du signal de réception (Y) sur la base d'une relation linéaire entre la partie réelle de phase (U), la partie imaginaire de phase (V), le biais ($\beta$) et les trois valeurs consécutives (Y1, Y2, Y3) du signal de réception (Y).

7. Processeur (300, 400) pour déterminer une phase d'un signal de réception (Y) reçue en réaction à un signal de transmission avec une fréquence de transmission $f_w$ connue, ledit signal de réception (Y) ayant une fréquence d'échantillonnage $f_s$ connue,
   **caractérisé par**
   un premier registre d'entrée (301), un deuxième registre d'entrée (302) et un troisième registre d'entrée (303), qui sont chacun configurés pour stocker trois valeurs consécutives (Y1, Y2, Y3) d'une pluralité de valeurs consécutives du signal de réception (Y) les unes après les autres ;
   un premier registre interne (341) et un deuxième registre interne (342), qui sont chacun configurés pour stocker une première valeur différentielle ($\Delta Y1$) comme différence du contenu (Y2) du deuxième registre d'entrée (302) et du contenu (Y1) du premier registre d'entrée (301) et pour stocker une deuxième valeur différentielle ($\Delta Y2$) comme différence du contenu (Y3) du troisième registre d'entrée (303) et du contenu (Y2) du deuxième registre d'entrée (302) ;
   un premier registre de sortie (361, 481) et un deuxième registre de sortie (362, 482), qui sont chacun configurés pour mettre à disposition une partie réelle de phase (U) et une partie imaginaire de phase (V) du signal de réception (Y) ; et

une unité de compte (305, 405), qui est configurée pour déterminer la partie réelle de phase (U) et la partie imaginaire de phase (V) du signal de réception (Y) sur la base d'une relation linéaire entre la partie réelle de phase (U), la partie imaginaire de phase (V) et les deux valeurs différentielles (ΔY1, ΔY2).

8. Processeur (300, 400) selon la revendication 7, comprenant :

un troisième registre de sortie (363, 483), qui est configuré pour mettre à disposition un biais (β) du signal de réception (Y),
dans lequel l'unité de compte (305, 405) est configurée pour déterminer le biais (β) du signal de réception (Y) sur la base d'une relation linéaire entre la partie réelle de phase (U), la partie imaginaire de phase (V), le biais (β) et les trois valeurs consécutives (Y1, Y2, Y3) du signal de réception (Y).

9. Processeur (300, 400) selon la revendication 8, comprenant :
un premier registre de coefficient (321), un deuxième registre de coefficient (311), un troisième registre de coefficient (322) et un quatrième registre de coefficient (312), qui sont chacun configurés pour stocker des coefficients de Fourier, lesdits coefficients de Fourier déterminant la relation linéaire entre la partie réelle de phase (U), la partie imaginaire de phase (V) et les deux valeurs différentielles (ΔY1, ΔY2).

10. Processeur (300, 400) selon la revendication 9, comprenant :

une première mémoire de paramètre (352), qui est configurée pour stocker le cosinus (hC) de la moitié d'une fréquence angulaire Ω connue, qui dépend de la fréquence de transmission $f_w$ et de la fréquence d'échantillonnage $f_s$ ;
une deuxième mémoire de paramètre (351), qui est configurée pour stocker le sinus (hS) de la moitié de la fréquence angulaire Ω connue ;
une troisième mémoire de paramètre (354), qui est configurée pour stocker le cosinus (wC) de la fréquence angulaire Ω connue ; et
une quatrième mémoire de paramètre (353), qui est configurée pour stocker le sinus (wS) de la fréquence angulaire Ω connue.

11. Processeur (300, 400) selon la revendication 10,
dans lequel la fréquence angulaire Ω connue satisfait la condition suivante :

$$\Omega = 2\pi(f_w/f_s).$$

12. Processeur (300, 400) selon la revendication 10 ou 11,
dans lequel l'unité de compte (305, 405) est configurée pour déterminer la partie réelle de phase (U) et la partie imaginaire de phase (V) du signal de réception (Y) sur la base des contenus (C1, S1, C2, S2) des quatre registres de coefficient (321, 311, 322, 312) et sur la base des contenus (hC, hS, wC, wS) des quatre mémoires de paramètre (352, 351, 354, 353).

13. Processeur (300, 400) selon la revendication 12, comprenant :

une unité d'instruction (307, 407), qui est configurée
pour initialiser le premier registre de coefficient (321) avec le contenu (hC) de la première mémoire de paramètre (352) et pour initialiser le deuxième registre de coefficient (311) avec le contenu (hS) de la deuxième mémoire de paramètre (351) en réponse à un signal de reset (371) ; et
pour renouveler le premier registre de coefficient (321) avec le contenu (C2) du troisième registre de coefficient (322) et pour renouveler le deuxième registre de coefficient (311) avec le contenu (S2) du quatrième registre de coefficient (312) en réponse à un signal d'horloge (370) ;
dans lequel l'unité d'instruction (307, 407) est configurée
pour charger le quatrième registre de coefficient (312) avec la valeur $C_1 wS + S_1 wC$ et pour charger le troisième registre de coefficient (322) avec la valeur $C_1 wC - S_1 wS$ en réponse au signal d'horloge (370),
dans lequel wS désigne le contenu de la quatrième mémoire de paramètre (353), wC désigne le contenu de la troisième mémoire de paramètre (354), $C_1$ désigne le contenu du premier registre de coefficient (321), $S_1$ désigne le contenu du deuxième registre de coefficient (311) et Ω désigne la fréquence angulaire connue

$\Omega = 2\pi (f_w/f_s)$ ;

dans lequel l'unité de compte (305, 405) est configurée pour déterminer la partie réelle de phase (U) comme

$$\frac{\Delta Y_1 \cdot S_2 - \Delta Y_2 \cdot S_1}{4hS \cdot hS \cdot hC} \text{ et la partie imaginaire de phase (V) comme } \frac{\Delta Y_1 \cdot C_2 - \Delta Y_2 \cdot C_1}{4hS \cdot hS \cdot hC} ,$$

dans lequel $hS$ désigne le contenu de la deuxième mémoire de paramètre (351), $hC$ désigne le contenu de la première mémoire de paramètre (352), $C_2$ désigne le contenu du troisième registre de coefficient (322), $S_2$ désigne le contenu du quatrième registre de coefficient (312) et $\Omega$ désigne la fréquence angulaire connue $\Omega = 2\pi (f_w/f_w)$.

14. Processeur (300, 400) selon la revendication 13,
dans lequel l'unité de compte (305, 405) est configurée pour déterminer le biais ($\beta$) comme $Y_2$ - ($U \cdot (S_1 hC + C_1 hS) + V \cdot (C_1 hC - S \cdot hS)$),
dans lequel U désigne la partie réelle de phase, V désigne la partie imaginaire de phase et $Y_2$ désigne le contenu du deuxième registre d'entrée (302).

15. Processeur (400) selon la revendication 12, comprenant
un premier registre auxiliaire (481) ;
un deuxième registre auxiliaire (482) ; et
un compteur (491), qui est incrémenté à chaque renouvellement des trois registres d'entrée (301, 302, 303) dépendant du signal d'horloge (370),
dans lequel l'unité de compte (405) est configurée pour déterminer la partie réelle de phase (U) comme $\Delta Y_1 S_2 - \Delta Y_2 S_1$ et la partie imaginaire de phase (V) comme $\Delta Y_1 C_2 - \Delta Y_2 C_1$, pour ajouter la partie réelle de phase (U) au premier registre auxiliaire (481) et pour ajouter la partie imaginaire de phase (V) au deuxième registre auxiliaire (482),
dans lequel l'unité d'instruction (407) est configurée
pour sortir les valeurs (AU, AV) des deux registres auxiliaires (481, 482) divisées par la valeur $2 \cdot wS \cdot hS = 4hS \cdot hS \cdot hC$ et divisées par une valeur (cnt) du compteur (491) en réponse à un signal d'interruption,
dans lequel $\Delta Y_1$ désigne le contenu du premier registre interne (341), $\Delta Y_2$ désigne le contenu du deuxième registre interne (342), $C_2$ désigne le contenu du troisième registre de coefficient (322), $S_2$ désigne le contenu du quatrième registre de coefficient (312), $hS$ désigne le contenu de la deuxième mémoire de paramètre (351) et $hC$ désigne le contenu de la première mémoire de paramètre (352) et $\Omega$ désigne la fréquence angulaire connue $\Omega = 2\pi (f_w/f_s)$.

100

L

105      107

104

103

101

$\varphi_0$      102      $\varphi_0$    $\varphi_1$

Fig. 1

200

201 — Empfangen einer Mehrzahl aufeinanderfolgender Werte eines Empfangssignals

202 — Bestimmen von zwei Differenzwerten aus jeweils zwei aufeinanderfolgenden Werten von drei aufeinanderfolgenden Werte des Empfangssignals

203 — Bestimmen eines Phasenrealteils und eines Phasenimaginärteils basierend auf einer linearen Beziehung zwischen dem Phasenrealteil, dem Phasenimaginärteil und den zwei Differenzwerten

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011107801 A1